# EUROPEAN PATENT APPLICATION

(11) **EP 4 814 853 A1**
(43) Date of publication of application: **30.09.2026**
(21) Application number: 24893888.8
(22) Date of filing: 09.10.2024
(51) Int. Cl.: G06Q 50/06, G01R 31/392

(54) **BATTERY INFORMATION MANAGEMENT SYSTEM**

(30) Priority: 21.11.2023 JP 2023197095
(71) Applicant: Hitachi High-Tech Corporation, Minato-ku Tokyo 105-6409 (JP)
(72) Inventor: HORIKOSHI Nobuya, Tokyo 105-6409 (JP); MAEDA Junichi, Tokyo 105-6409 (JP); TAKEZAKI Taiichi, Tokyo 105-6409 (JP); YOSHIMURA Mina, Tokyo 105-6409 (JP)
(74) Representative: MERH-IP Matias Erny Reichl Hoffmann Patentanwälte PartG mbB
(86) International application number: PCT/JP2024/036120
(87) International publication number: WO 2025/109894

(57) **Abstract**

An object of the invention is to provide a system platform capable of monitoring the timing and quantity of battery supply and demand. A battery information management system according to the invention holds specification data, deterioration state data, and use history data for each of a supply battery and a demand battery, and uses the information to calculate a supply quantity and a supply timing of the supply battery and a demand quantity and a demand timing of the demand battery (see FIG. 1).

## Description

### Technical Field

The present invention relates to a technology for managing battery information.

### Background Art

Secondary batteries deteriorate with use; however, even deteriorated used products may be sufficiently usable depending on the application. There is a potential need for such used batteries. For example, there is a need to effectively utilize valuable metal resources throughout the entire life cycle of secondary batteries by utilizing used batteries.

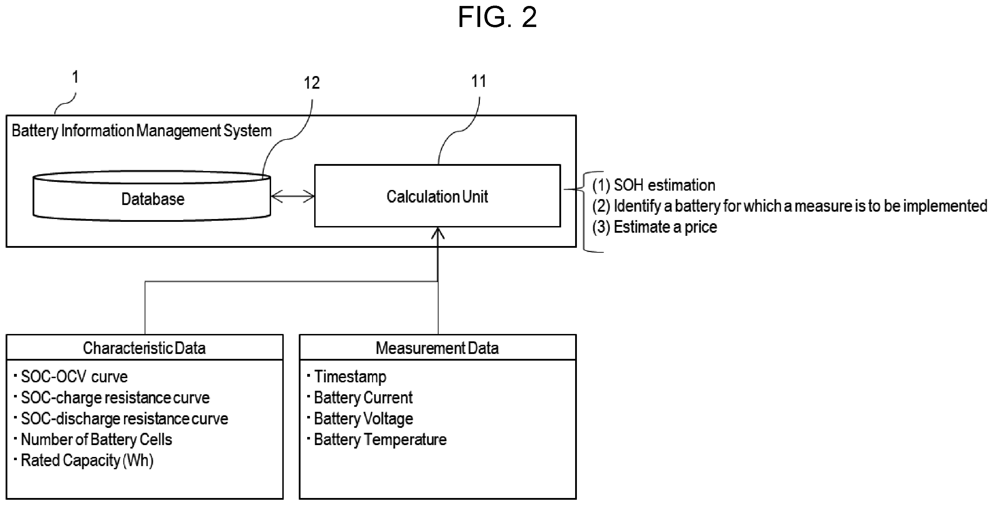

PTL 1 discloses a technology stating that: "The present disclosure discloses a technology for more accurately evaluating the residual value of a secondary battery. To this end, the present disclosure proposes a battery residual value management system that manages a residual value of a battery, the battery residual value management system including: at least one storage device that stores information of a multidimensional vector space defined by one or more threshold values set for each index in a multidimensional vector space composed of at least three indexes for evaluating the residual value of the battery and having a plurality of regions for determining ranks according to the residual value of the battery; and at least one processor that acquires the information of the multidimensional vector space from the storage device and determines, based on the at least three indexes of a battery subject to residual value assessment, which of the plurality of regions of the multidimensional vector space the battery subject to residual value assessment belongs to, thereby determining a rank according to the residual value of the battery subject to residual value assessment (see FIG. 2A)." (see Abstract).

PTL 2 describes, as a technology related to the invention, a method for calculating a battery capacity of a battery pack. The application describes a technology stating that: "A method for diagnosing a battery pack using a system that obtains detection data including a current and a temperature of a battery pack having a configuration in which a plurality of cells are connected in series and voltages of the respective cells, the method including: calculating an electric charge capacity and an SOC of each cell using the current and the temperature and the voltage of each cell, an SOC function of OCV, and a resistance table; calculating an imbalance amount, which is an estimated value of the SOC of each cell when the battery pack is fully charged, and resistance; and calculating an energy capacity of the battery pack using the electric charge capacity, the imbalance amount, and the resistance. This makes it possible to accurately calculate the energy capacity of the battery pack even in an imbalanced state." (see Abstract).

Japanese Patent Application No. 2023-038292 describes a technology related to the invention. The document discloses a technology stating that, as a problem, "a technology is provided that can appropriately select a measure having a high economic effect and a timing for implementing the measure, as a measure to be implemented when a secondary battery has deteriorated," and that "a battery deterioration degree management system according to the invention calculates a cost required for implementing the measure based on cost data describing a cost associated with implementing a measure for deterioration of a deterioration state of a battery, and determines, based on the cost, the measure having a high economic effect and the timing for implementing the measure." (see Abstract).

### Citation List

### Patent Literature

PTL 1: WO2023/139684A1
PTL 2: WO2022/024885A1

### Summary of Invention

### Technical Problem

Conventional technologies such as PTL 1 are intended to provide matching between a request of a battery demander and a residual value of a battery. However, they do not sufficiently consider at what time point and in what amount batteries are required in a market. Similarly, with respect to a battery supplier, the time point at which batteries are supplied and the amount of batteries supplied are not sufficiently considered. Accordingly, there is a need for a mechanism capable of matching a battery supplier and a battery demander in consideration of these conditions.

The invention has been made in view of the above-described problems, and an object thereof is to provide a system platform capable of ascertaining timing and quantity for each of supply and demand of batteries.

### Solution to Problem

A battery information management system according to the invention holds specification data, deterioration state data, and use history data for each of a supply battery and a demand battery, and uses these pieces of information to calculate a supply quantity and a supply timing of the supply battery and to calculate a demand quantity and a demand timing of the demand battery.

### Advantageous Effects of Invention

According to the battery information management system according to the invention, it is possible to provide a system platform capable of ascertaining timing and quantity for each of supply and demand of batteries. Other problems, configurations, effects, and the like of the invention will become apparent from the following description of embodiments.

### Brief Description of Drawings

[FIG. 1] FIG. 1 is a configuration diagram of a battery information management system 1 according to Embodiment 1.
[FIG. 2] FIG. 2 illustrates an example of data used when the battery information management system 1 acquires information about supply batteries.
[FIG. 3] FIG. 3 is a schematic diagram illustrating a processing flow performed by a calculation unit 11.
[FIG. 4] FIG. 4 illustrates results of predicting a temporal change in SOH of battery cells.
[FIG. 5A] FIG. 5A illustrates an example of input/output data when a market in which used batteries are traded between a battery supplier 2 and a battery demander 3 is formed.
[FIG. 5B] FIG. 5B illustrates an example of input/output data when financing is received using an asset price of a battery as collateral.
[FIG. 5C] FIG. 5C illustrates an example of input/output data when used batteries are reused or recycled.
[FIG. 5D] FIG. 5D illustrates an example of input/output data when ascertaining a sale amount of a battery damaged by oneself.
[FIG. 5E] FIG. 5E illustrates an example of input/output data when a used electric vehicle is reused as it is as one form of reuse of a used battery.
[FIG. 5F] FIG. 5F illustrates an example of input/output data when the battery information management system 1 diagnoses a used battery and presents a result thereof.
[FIG. 5G] FIG. 5G illustrates another example of input/output data when the battery information management system 1 diagnoses a used battery and presents a result thereof.
[FIG. 6A] FIG. 6A illustrates an example of a GUI when the battery information management system 1 estimates a battery price.
[FIG. 6B] FIG. 6B illustrates an example of a GUI when the battery information management system 1 presents a standard price list of batteries.
[FIG. 6C] FIG. 6C illustrates an example of a GUI when a battery demander 3 searches for a desired battery.

### Description of Embodiments

### <Embodiment 1>

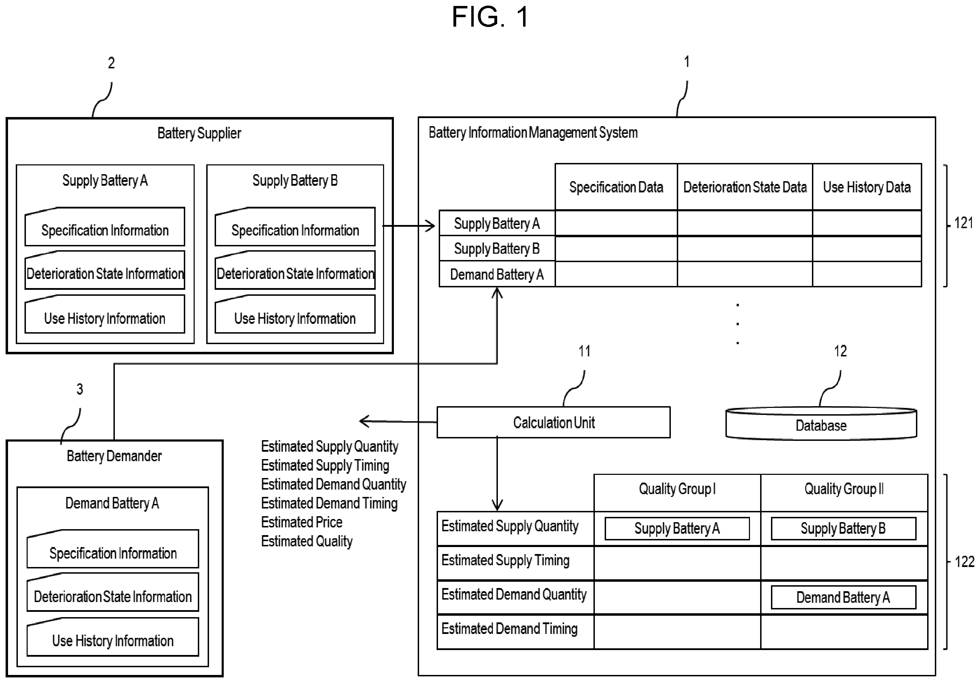

FIG. 1 is a configuration diagram of the battery information management system 1 according to Embodiment 1 of the invention. The battery information management system 1 is a system that respectively manages information about a supply battery supplied from the battery supplier 2 and information about a demand battery supplied from the battery demander 3. The battery information management system 1 includes the calculation unit 11 and a database 12.

The calculation unit 11 acquires, from the battery supplier 2, information about a supply battery. The supply battery is a battery supplied from the battery supplier 2 to a market, and is typically a used battery but may be a new battery. The information about the supply battery includes specification information of the supply battery, deterioration state information of the supply battery, and use history information of the supply battery. The calculation unit 11 acquires these pieces of information and stores them in the database 12 as specification data, deterioration state data, and use history data (battery information data 121) of each supply battery.

The calculation unit 11 acquires, from the battery demander 3, information about a demand battery. The demand battery is a battery that the battery demander 3 desires the market to supply, and is typically a used battery but may be a new battery. The information about the demand battery includes specification information of the demand battery, deterioration state information of the demand battery, and use history information of the demand battery. The calculation unit 11 acquires these pieces of information and stores them in the database 12 as specification data, deterioration state data, and use history data (battery information data 121) of each demand battery.

The calculation unit 11 estimates, based on the battery information data 121, an amount of supply batteries supplied in the market (estimated supply quantity) and a supply timing thereof (estimated supply timing). Similarly, the calculation unit 11 estimates, based on the battery information data 121, an amount in which demand for demand batteries occurs in the market (estimated demand quantity) and a demand timing thereof (estimated demand timing). For example, the following Examples 1 to 4 are conceivable as estimation methods, but any estimation method may be used without limitation thereto.

### (Example 1 of estimation method for timing and quantity)

The calculation unit 11 ascertains a transition of a deterioration state of supply batteries based on deterioration state data and, based thereon, estimates a timing and an amount at which the supply batteries are released to the market. When deterioration of a battery progresses and reaches a certain degree, the battery is discarded or released to the market as a used product. That is, there is a statistical relationship between the deterioration state of the battery and the timing at which the battery is released to the market. The calculation unit 11 can estimate the supply timing of the supply battery based on this statistical relationship. Furthermore, because the battery information data 121 holds information about a plurality of supply batteries, this statistical relationship can be described as a statistic for an aggregate of the plurality of supply batteries. Accordingly, the calculation unit 11 can estimate the supply quantity at each timing together with the supply timing of the supply batteries. The calculation unit 11 outputs these estimation results.

### (Example 2 of estimation method for timing and quantity)

Similarly, for demand batteries, the calculation unit 11 ascertains a transition of a deterioration state required for demand batteries based on deterioration state data and, based thereon, estimates a timing and an amount at which the demand batteries are required in the market. The calculation unit 11 outputs these estimation results.

### (Example 3 of estimation method for timing and quantity)

In addition to or in place of the above, the calculation unit 11 may ascertain how the supply batteries have been used so far from use history data and, based thereon, estimate a timing and an amount at which the supply batteries are released to the market. For example, it is possible to ascertain, from use history data, a manner of use such as repeatedly performing full charge and full discharge at a rated C-rate for 12 hours of a day and resting for the remaining 12 hours. It is considered that there is a statistical relationship between how a battery is used and the deterioration state of the battery. That is, how the battery is used has information similar to the deterioration state of the battery. Accordingly, the calculation unit 11 can estimate the amount and timing at which the supply batteries are released to the market based on the use history data.

### (Example 4 of estimation method for timing and quantity)

The use history of a demand battery indicates what kind of batteries, used in what manner, are in demand. Accordingly, similarly for demand batteries, the calculation unit 11 ascertains a past manner of use required for demand batteries based on use history data and, based thereon, estimates a timing and an amount at which the demand batteries are required in the market. The calculation unit 11 outputs these estimation results.

When estimating the supply quantity/supply timing/demand quantity/demand timing, the calculation unit 11 may classify supply batteries and demand batteries in advance for each quality group and estimate the supply quantity/supply timing/demand quantity/demand timing for each quality group. Estimated result data 122 illustrated in FIG. 1 is an example in which results estimated in this manner are stored in the database 12. The quality group as used herein is a classification of batteries according to quality index values thereof, and for example, a numerical range of deterioration states can be used as a quality group. Other specific examples of quality groups include: (a) battery specifications such as battery type, battery form, date of manufacture, capacity, and quantity; and (b) environment and conditions for use on the important side (temperature, humidity, charging frequency, charging speed, and lifetime).

The calculation unit 11 may further classify the quality groups of the batteries according to battery application and estimate the supply quantity/supply timing/demand quantity/demand timing for each combination of quality group/application or for each application. The battery applications as used herein are, for example, reuse, recycling, and the like. Reuse is, for example, reconstructing a battery having large deterioration as a refurbished product. Recycling is, for example, diverting a battery from a current application to another application.

FIG. 2 illustrates an example of data used when the battery information management system 1 acquires information about supply batteries. The calculation unit 11 may receive characteristic data and measurement data, use these pieces of data to estimate SOH (at present and at a predetermined future timing) of a battery, and further reflect a result thereof in the database 12 as deterioration state data. Any known technology may be used as an estimation procedure. Based on the estimated SOH, the calculation unit 11 identifies a battery whose deterioration has progressed and determines a measure (reuse, recycling, or the like) to be implemented for the battery. Specific examples of measures and determination procedures will be described later.

The characteristic data is data describing physical characteristics of a battery, and can be acquired in advance before estimating SOH. The characteristic data describes an SOC-OCV curve, an SOC-charge resistance curve, an SOC-discharge resistance curve, the number of battery cells, a rated capacity (Wh), and the like. The SOC-OCV curve describes a relationship between SOC (State Of Charge) of the battery and OCV (Open Circuit Voltage). The SOC-charge resistance curve describes a relationship between SOC of the battery and charge resistance. The SOC-discharge resistance curve describes a relationship between SOC of the battery and discharge resistance. The number of battery cells is the number of cells constituting the battery. The rated capacity (Wh) is a rated capacity of the battery.

The measurement data is data describing results obtained by measuring a physical state of the battery, and can be acquired, for example, from a battery management unit (BMU). The measurement data describes a timestamp, battery current, battery voltage, battery temperature, and the like. The timestamp is a date and time at which the measurement data was acquired (or at which measurement was performed). The battery current, the battery voltage, and the battery temperature are, respectively, an output current of the battery, an output voltage of the battery, and a temperature of the battery (or a temperature of an environment surrounding the battery).

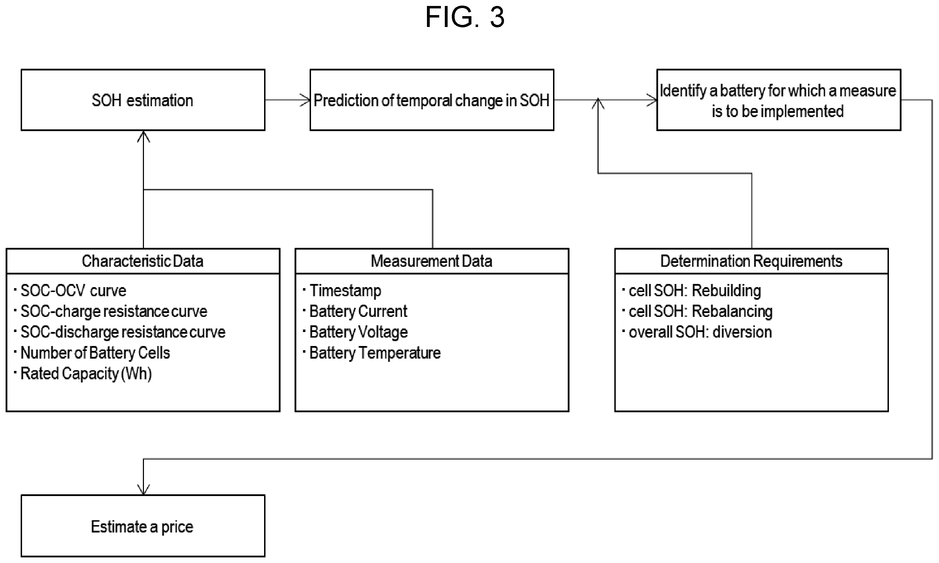

FIG. 3 is a schematic diagram illustrating a processing flow performed by the calculation unit 11. The calculation unit 11 estimates SOH of the battery using the characteristic data and the measurement data. Specifically, a battery capacity can be calculated using an integrated value of a current value during charging and SOC of the battery at a start and an end of charging. Furthermore, SOH can be estimated based on "SOH = 100 × battery capacity / rated capacity of battery." Alternatively, any known technology such as PTL 2 may be used. As another method, for example, a temporal change in battery voltage during a rest period after a charging operation or a discharging operation may be acquired, and SOH may be estimated based on a correspondence relationship between the temporal change and SOH.

The calculation unit 11 predicts a temporal change in SOH. Because SOH gradually decreases with time, a future temporal change in SOH can be predicted, for example, based on a time decrease rate thereof. Prediction may be performed using any other method. The future temporal change in SOH may be predicted by linear approximation, may be approximated by ARMA (autoregressive moving average) or a Weibull distribution, or may be predicted using any other method. A prediction result can be output as an estimated quality of the battery.

The calculation unit 11 identifies a battery whose SOH has decreased, and further determines a measure to be implemented for the battery. Examples of the measure to be implemented include: (a) rebalancing for equalizing states of charge of respective batteries constituting a battery group; (b) rebuilding (or reuse) for regenerating a battery having large deterioration (reconstructing the battery as a refurbished product); and (c) diversion to another application. The determined measure can be presented together with other calculation results.

For example, a battery cell whose deterioration has progressed exhibits a larger decrease in SOC during discharging than other battery cells. Rebalancing is a process of equalizing SOC between a battery cell whose deterioration has progressed and a battery cell whose deterioration has not progressed. This enables the entire battery group to exhibit performance close to a rated capacity. In this respect, rebalancing is suitable as a measure to be implemented for a battery cell whose deterioration has progressed.

When deterioration of a battery cell progresses beyond a degree to which performance can be recovered by rebalancing, a measure other than rebalancing is required. Rebuilding is selected as a measure for such a battery cell. Specifically, the battery cell whose deterioration has progressed is taken out from the battery group and reconstructed as a refurbished product. More simply, the battery cell whose deterioration has progressed may be replaced with a new battery. In the present embodiment, this is also regarded as rebuilding in a broad sense.

From a viewpoint different from that of battery cells, a measure may be implemented for the entire battery group. For example, when SOH of the entire battery group gradually deteriorates, the battery group may still be usable but may not satisfy performance requirements in the current use environment. In such a case, it is conceivable to divert the battery group to another use environment in which performance requirements are more relaxed. Conversely, when SOH of the entire battery group is sufficiently high, it is conceivable to divert the battery group to another use environment in which performance requirements are stricter. The battery group as used herein may be a battery module including a plurality of battery cells, a battery pack including a plurality of battery modules, or any other unit.

Diverting a battery also includes recycling the battery by disassembling the battery and taking out materials. Accordingly, applications at a diversion destination are deemed to include recycling applications, and these are treated as "diversion" in a broad sense.

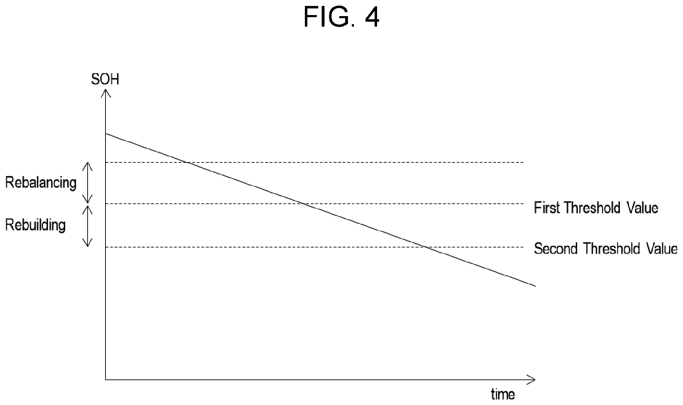

FIG. 4 illustrates results of predicting a temporal change in SOH of battery cells. When deterioration of SOH is relatively small (SOH is equal to or greater than a first threshold value), rebalancing can be selected as a measure. When deterioration of SOH further progresses (SOH is equal to or less than the first threshold value and equal to or greater than a second threshold value), rebuilding can be selected as a measure. On the vertical axis of FIG. 4, a section in which rebalancing is selected and a section in which rebuilding is selected may be adjacent to each other or may not be adjacent to each other. When the two sections are not adjacent to each other, a measure to be implemented in a gap portion between the two sections may be either rebalancing or rebuilding, for example.

In addition to estimating the supply quantity/supply timing/demand quantity/demand timing, the calculation unit 11 may estimate a market price of a battery at a predetermined time point. Since the market price is determined by a balance between demand and supply, the market price can also be estimated by estimating the supply quantity/supply timing/demand quantity/demand timing. For example, the market price at that timing can be estimated by inputting the estimated supply quantity/supply timing/demand quantity/demand timing into a price model constructed in advance. Furthermore, because the deterioration state of the supply battery is used when estimating the supply quantity/supply timing/demand quantity/demand timing, it is also possible to estimate a quality of a battery supplied in the market at that timing. The calculation unit 11 outputs these estimation results.

As another method by which the calculation unit 11 estimates the market price of the battery, it is conceivable to estimate the market price by referring to an actual market price. Alternatively, (a) new battery supply forecast data predicting a supply quantity of new batteries by region may be acquired, (b) a supply quantity of used batteries by region may be predicted using this data, and (c) an estimated price at a predetermined timing of batteries supplied in the market may be estimated using prediction results of the predicted supply quantity of used batteries. The above estimation methods may be used in combination to obtain respective estimation results, and these may be subjected to a weighted average or the like.

### <Embodiment 1: Summary>

The battery information management system 1 according to Embodiment 1 calculates the supply quantity/supply timing/demand quantity/demand timing using information about supply batteries acquired from the battery supplier 2 and information about demand batteries acquired from the battery demander 3, and outputs results thereof. In calculating these, highly accurate information can be presented by using not only SOH of used batteries but also information about past SOH transitions and how the batteries have been used. Furthermore, it is possible to predict the quality and quantity of used batteries that will be released to the market in the future. By presenting these, a futures market for used batteries can be formed.

The battery information management system 1 according to Embodiment 1 estimates a market price of a supply battery at a predetermined timing and presents a result thereof. This enables the battery supplier 2 to ascertain an asset value of a used battery owned by the battery supplier 2. If the asset value can be ascertained, it becomes possible to obtain financing using the used battery as collateral. For example, a leasing business operator that owns electric vehicles can obtain business funds using the owned electric vehicles as collateral.

The estimated market price of a supply battery presented by the battery information management system 1 according to Embodiment 1 can also be used as a standard price list. By presenting standard prices together with specification data/deterioration state data/use history data, it is possible to revitalize a used battery market and to lower psychological and economic hurdles to transactions by making it easier to ascertain abnormal prices.

The battery information management system 1 according to Embodiment 1 determines, based on a deterioration state of a battery and the like, a measure to be implemented for the battery and presents the determined measure. Since required battery performance and the like differ depending on the type of measure, the application at the diversion destination, and the like, presenting the measure together with battery specification data/deterioration state data/use history data makes it possible to match demand and supply of used batteries for each application.

The battery information management system 1 according to Embodiment 1 may store information about a location of a battery (a location where the battery is supplied in the case of a supply battery, and a location where demand exists in the case of a demand battery) in the database 12 together with specification data/deterioration state data/use history data of the battery. Information about the location can be acquired from the battery supplier 2 in the case of a supply battery, and from the battery demander 3 in the case of a demand battery. The battery information management system 1 may present the information about the location of the battery together with the specification data/deterioration state data/use history data of the battery. Accordingly, for example, information about a supply battery to be released for a recycling application can be presented together with the location of the battery.

The battery information management system 1 according to Embodiment 1 presents information about quality (specifications, SOH, and use history) of supply batteries/demand batteries. For example, a battery manufacturer or a manufacturer of a product equipped with a battery can refer to this information to create a production plan. Furthermore, a demander can ascertain in advance the quality and quantity of batteries predicted to be available in the market at a certain future timing, and thus futures transactions for that future supply become possible.

### <Embodiment 2>

Embodiment 2 of the invention illustrates specific applications of the battery information management system 1. The configuration of the battery information management system 1 is the same as that of Embodiment 1.

Since the battery information management system 1 described in Embodiment 1 presents an estimated price of a used battery, it is conceivable to use the battery information management system 1 in the insurance business. For example, when an electric vehicle is totally damaged by an accident, after an insurance company pays insurance proceeds, the electric vehicle is owned by the insurance company, and therefore a sale price of a battery mounted on the electric vehicle directly affects profit and loss of the insurance company. Accordingly, the insurance company has a need to know an accurate sale price of the battery. The battery information management system 1 can satisfy such a need by presenting an estimated price of the battery to the insurance company. However, because a damaged battery generally has a high transportation cost, it is desirable to present information about a supply location/demand location together with the estimated price.

On the other hand, by using the battery information management system 1 by an owner of an electric vehicle, the owner of the electric vehicle can ascertain a correct battery value when the electric vehicle is totally damaged. Alternatively, by ascertaining the battery value over time, it is possible to set appropriate prices of automobile insurance, insurance menus, and the like more appropriately.

Even if the battery supplier 2 requests a battery manufacturer to replace a deteriorated battery, replacement may be refused for a reason such as the battery being sufficiently usable with its current quality. By presenting information about battery performance and the like, the battery information management system 1 can quantitatively present battery quality to the battery manufacturer, and thus can suppress such refusal of replacement. In other words, it is possible to make a battery quality assurance service easier to receive.

The battery information management system 1 described in Embodiment 1 can be used for the battery demander 3 to transversely search a plurality of battery suppliers 2 for a desired battery. Specifically, information about batteries is stored in the database 12 together with information about contact information and the like of the battery suppliers 2, and the battery demander 3 notifies the calculation unit 11 of specifications and the like required for a supply battery. The calculation unit 11 searches the database 12 for a battery matching the requirements and presents a result thereof. Information about the battery supplier 2 for each battery may or may not be presented together. This is useful because, for example, a battery demander 3 (e.g., an electric power storage business operator) that needs to acquire a large number of batteries having similar deterioration states and specifications can collectively search for desired batteries. In addition to searching, functions such as purchase reservation, receiving periodic information updates about target batteries, and automatically contacting a purchase reservation holder when a purchase timing approaches may also be implemented.

### <Embodiment 3>

Embodiment 3 of the invention illustrates, among specific applications of the battery information management system 1, an application relating to diagnostic results for battery cells. The configuration of the battery information management system 1 is the same as that of Embodiment 1.

The calculation unit 11 estimates a deterioration state of a battery and presents a result thereof, and at that time may also present a method for recovering the deterioration state. For example, when a battery is configured by an assembly of battery cells, even if some cells have deteriorated and take longer to charge than other cells, a battery management system (BMS) may stop charging while the deteriorated cells remain uncharged. In this case, simply charging only the deteriorated cells may increase SOH of the entire battery by several points. Therefore, the calculation unit 11 may diagnose the deterioration state for each battery cell and present a result thereof, and when some cells are significantly more deteriorated than other cells, may suggest charging only the deteriorated cells.

Since a central portion of a battery pack has a higher temperature than a peripheral portion, battery cells in the central portion generally deteriorate faster than battery cells in the peripheral portion. If a diagnostic result different from this is obtained by individually diagnosing the battery cells, there is a possibility that a manufacturing problem has occurred in the battery pack. Therefore, the calculation unit 11 may feed back diagnostic results for each battery cell to a manufacturing process. This enables the manufacturing process to ascertain the possibility of a manufacturing process problem as described above.

### <Embodiment 4>

Embodiment 4 of the invention describes specific examples of data input to and output from the battery information management system 1 in the above embodiments. The configuration of the battery information management system 1 is the same as those of the above embodiments. The input/output data is processed by the calculation unit 11.

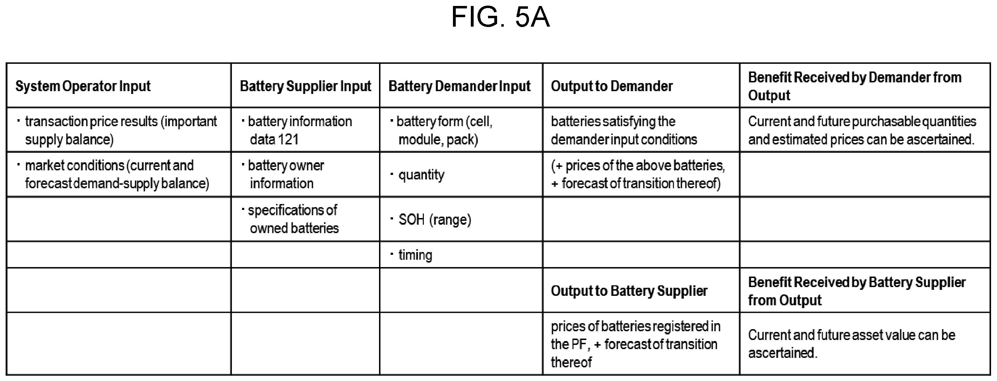

FIG. 5A illustrates an example of input/output data when a market in which used batteries are traded between the battery supplier 2 and the battery demander 3 is formed. An operator of the battery information management system 1 inputs past transaction results, price conditions in an external market, and the like to the battery information management system 1. The battery supplier 2 provides information about the battery supplier 2 itself (e.g., contact information) in addition to battery information. The battery demander 3 specifies specifications and the like of a desired battery. The battery information management system 1 presents a supply quantity, specifications, price, and the like of used batteries matching the demand. Accordingly, both the battery supplier 2 and the battery demander 3 can ascertain a battery price at a specified timing. As one example, the battery demander 3 specifies specifications, quantity, and the like of a desired battery, and the battery supplier 2 can make a sale decision by looking at that information and price.

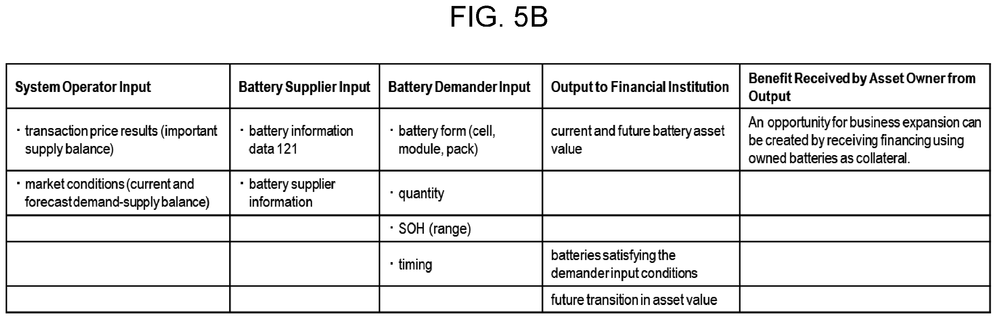

FIG. 5B illustrates an example of input/output data when financing is received using an asset price of a battery as collateral. In this example, since a financial institution that provides financing needs to ascertain the asset price of the battery, the financial institution acquires information about the battery price at a predetermined timing.

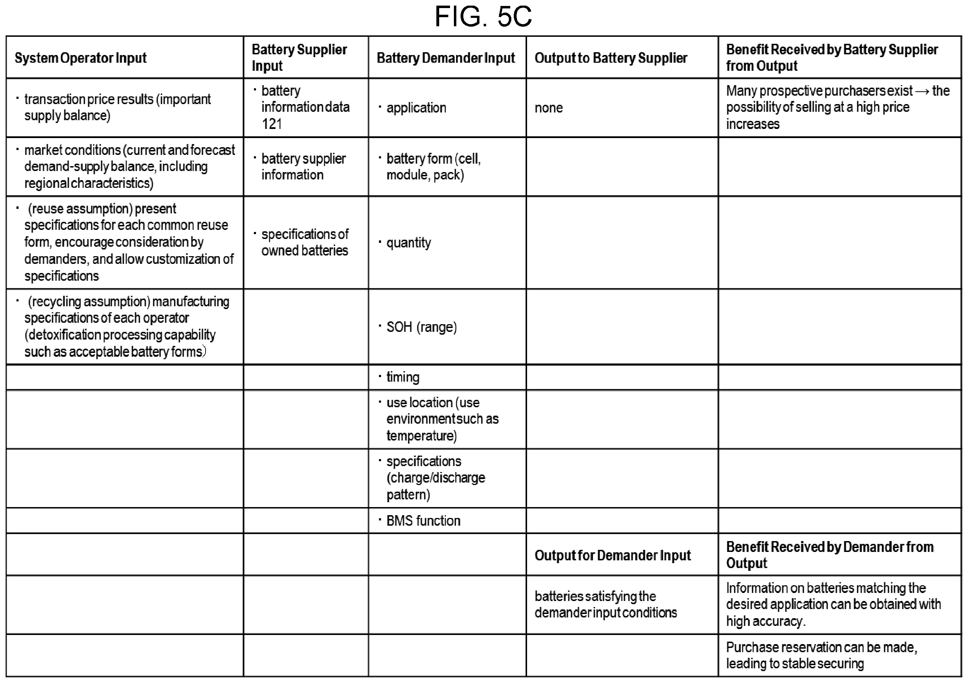

FIG. 5C illustrates an example of input/output data when used batteries are reused or recycled. The operator of the battery information management system 1 may input, in advance as templates, battery specifications assumed for reuse/recycling, respectively. The battery demander 3 specifies an application for each of reuse/recycling. Since demand for reuse/recycling also relates to a demand location, a location where the used batteries are used may also be specified.

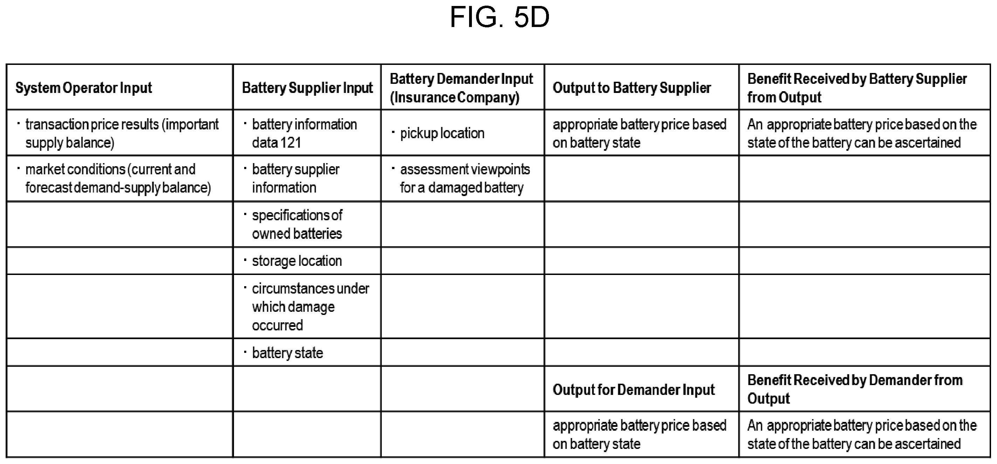

FIG. 5D illustrates an example of input/output data when ascertaining a sale amount of a battery damaged by oneself. In order to consider a cost for transporting the damaged battery, the battery supplier 2 provides information about a storage location of the battery. Furthermore, as reference information, information about surrounding circumstances when the damage occurred and a state of the battery itself may be provided. The battery demander 3 (for example, an insurance company) specifies a location where the battery is picked up. If the battery demander 3 is an insurance company, viewpoints for assessing the battery may be presented as reference information.

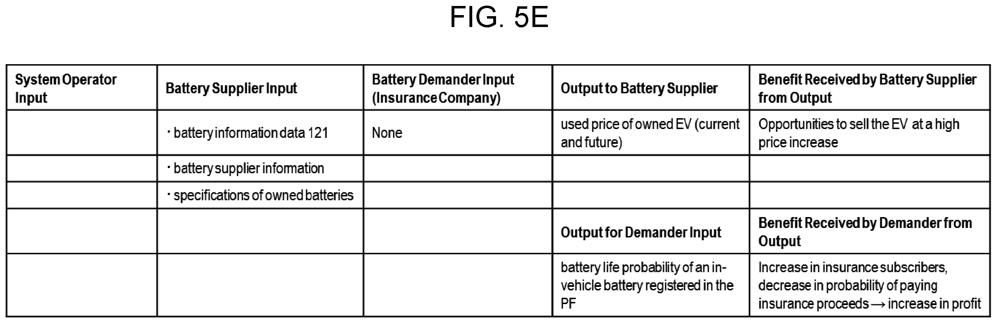

FIG. 5E illustrates an example of input/output data when a used electric vehicle is reused as it is as one form of reuse of a used battery. A price at a predetermined timing of the used battery (and, if possible, the used electric vehicle) is presented to the battery supplier 2. For the battery demander 3, in addition to the battery price, a predicted lifetime of the used battery mounted on the electric vehicle may be presented. Any method may be used for predicting the lifetime; for example, SOH at a specified time point may be predicted based on a temporal change in SOH, and the lifetime may be predicted based thereon (e.g., when SOH becomes less than a reference value, it is regarded that the lifetime has been reached). In this example, an advantage for the battery supplier 2 is that opportunities to sell used electric vehicles increase. An advantage for the battery demander 3 is that, if the battery demander 3 is an insurance company, for example, the battery price can be referred to as a basis for calculating an insurance premium for automobile insurance. Furthermore, presenting the battery lifetime gives motivation to subscribe to insurance, which may reduce the statistical probability of paying insurance proceeds and increase company profit.

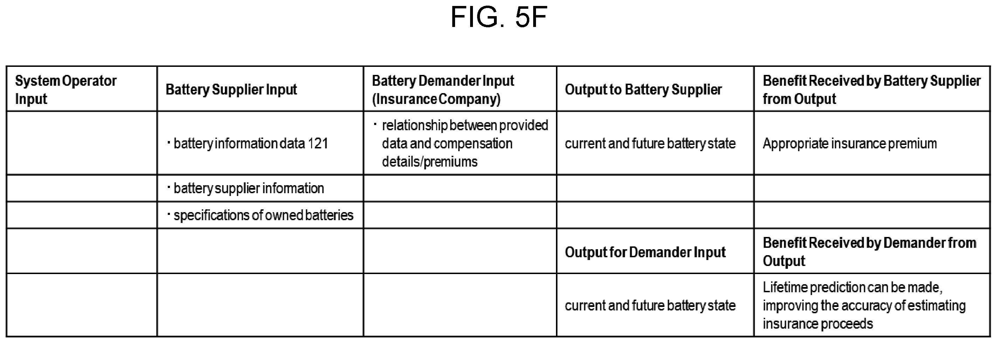

FIG. 5F illustrates an example of input/output data when the battery information management system 1 diagnoses a used battery and presents a result thereof. When the battery demander 3 is an insurance company, the battery supplier 2 has a need to ascertain an appropriate insurance premium according to a battery state. The battery demander 3 provides, in advance, information about a relationship between the battery state and compensation details/premiums. The battery information management system 1 calculates and presents an appropriate insurance premium based thereon. Accordingly, the battery supplier 2 can ascertain the insurance premium, and the battery demander 3 has an advantage of being able to set appropriate insurance proceeds/premiums based on lifetime prediction.

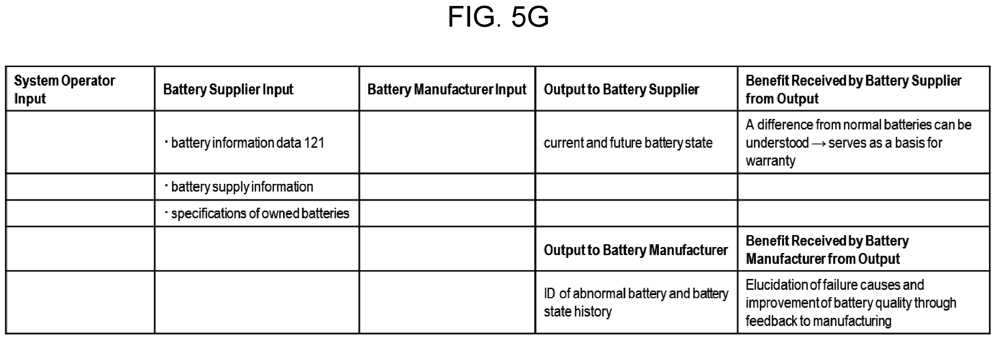

FIG. 5G illustrates another example of input/output data when the battery information management system 1 diagnoses a used battery and presents a result thereof. In this example, battery diagnostic information is fed back to a battery manufacturer. Accordingly, the advantages described in Embodiment 3 are obtained. Alternatively, for the battery supplier 2, as described in Embodiment 2, there is an advantage in that it becomes easier to obtain a warranty from the battery manufacturer.

### <Embodiment 5>

Embodiment 5 of the invention gives examples of a user interface (Graphical User Interface: GUI) presented by the battery information management system 1. The GUI can be provided by the calculation unit 11.

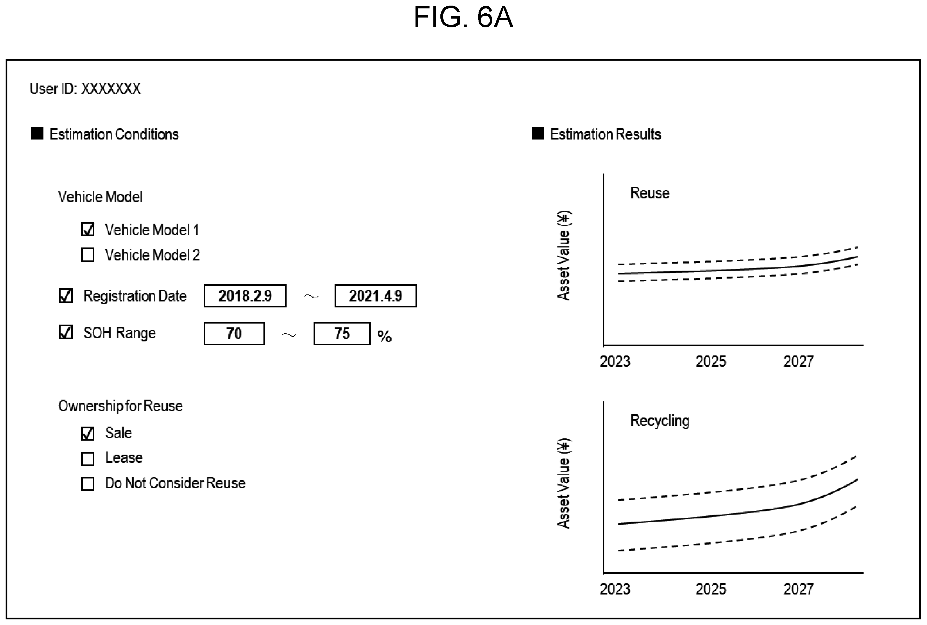

FIG. 6A illustrates an example of a GUI when the battery information management system 1 estimates a battery price. A user (the battery supplier 2 or the battery demander 3) inputs information for specifying a battery for which a price is to be estimated. The calculation unit 11 estimates the battery price according to specified conditions and outputs a result thereof. The battery price may be estimated for each timing or for each reuse/recycling application.

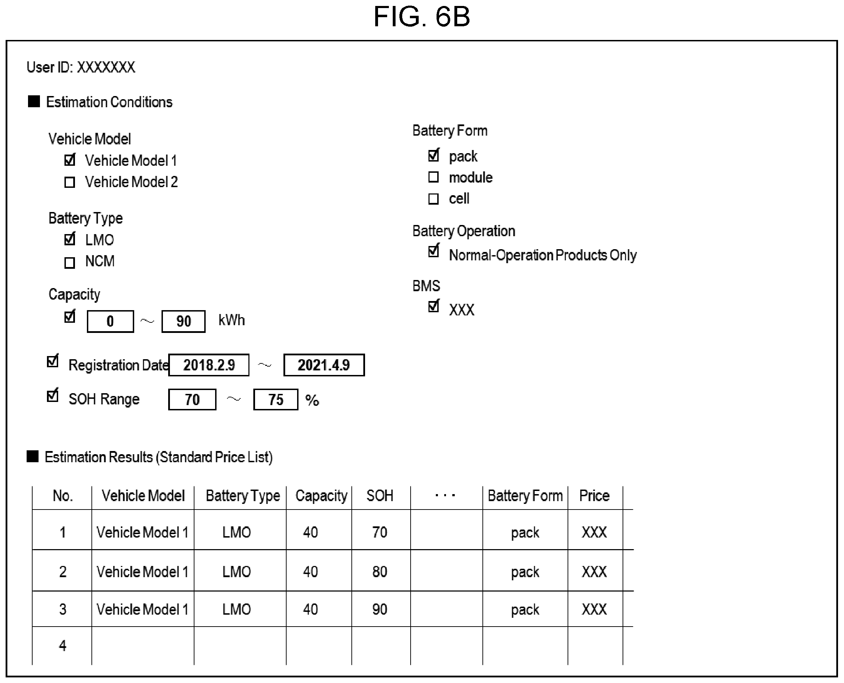

FIG. 6B illustrates an example of a GUI when the battery information management system 1 presents a standard price list of batteries. The standard price has an aspect as an estimation result of the battery price. The user inputs information for specifying a battery for which a standard price is to be calculated. The calculation unit 11 estimates the standard price according to specified conditions and outputs a result thereof.

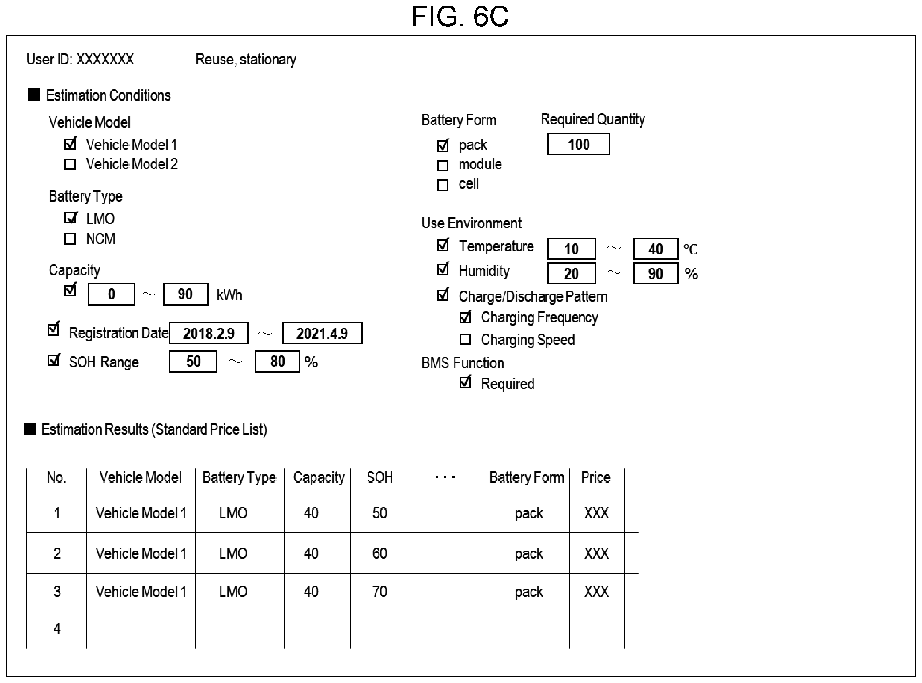

FIG. 6C illustrates an example of a GUI when the battery demander 3 searches for a desired battery. The battery demander 3 specifies conditions of a desired battery. The calculation unit 11 searches the database 12 for a battery matching the specified conditions and outputs a result thereof.

### <Modifications of Invention>

The invention is not limited to the embodiments described above, and includes various modifications. For example, the embodiments described above have been described in detail for easy understanding of the invention, and are not necessarily limited to having all configurations described. In addition, a part of the configuration of one embodiment can be replaced with the configuration of another embodiment, and the configuration of another embodiment can be added to the configuration of one embodiment. Further, another configuration can be added to, deleted from, or substituted for a part of the configuration of each embodiment.

In the above embodiments, the calculation unit 11 may estimate at least one of a price/supply quantity/supply timing/demand quantity/demand timing of a battery based on transaction results on the battery information management system 1. Alternatively, in place of or in addition to this, any one of these may be estimated based on a transaction history of batteries in the market.

In the above embodiments, when the battery supplier 2 introduces a battery, a period during which use of the battery is permitted may be stipulated as a contractual condition. This period serves as a basis for estimating the supply quantity/supply timing of the battery. The calculation unit 11 may acquire this contractual condition and, based thereon, estimate at least one of the supply quantity and the supply timing.

In the above embodiments, the calculation unit 11 may exchange data with a system separate from the battery information management system 1. For example, results of estimation/search and the like performed by the calculation unit 11 may be described in a general-purpose data format, and the data may be provided to an external system.

In the above embodiments, the calculation unit 11 may be configured by hardware such as a circuit device implementing its functions, or may be configured by causing an calculation device such as a CPU (Central Processing Unit) to execute software implementing its functions.

In the above embodiments, the calculation unit 11 may acquire evidence for proving that a battery has been recycled, and may leave a record to that effect in the database 12. For example, when a fleet business operator having battery assets intends to send deteriorated batteries for recycling, it is conceivable to store, in the database 12, records that enable tracking of each battery before and after recycling.

### Reference Signs List

1: battery information management system
11: calculation unit
12: database

## Claims

1. A battery information management system that manages information of a battery, comprising:
a database that stores the information; and
a calculation unit that calculates information about demand or supply of the battery using the information stored in the database,
wherein the database stores, as the information of supply batteries supplied to a market:
specification data describing specifications of the supply batteries;
deterioration state data describing deterioration states of the supply batteries; and
use history data describing use histories of the supply batteries,
wherein the calculation unit uses the information of the supply batteries stored in the database to calculate, for each quality group into which the supply batteries are classified according to quality thereof, a supply quantity of the supply batteries and a supply timing of the supply batteries,
wherein the database further stores, as the information of demand batteries for which there is demand from the market:
specification data describing specifications required for the demand batteries;
deterioration state data describing deterioration states required for the demand batteries; and
use history data describing use histories required for the demand batteries, and
wherein the calculation unit uses the information of the demand batteries stored in the database to calculate, for each quality group into which the demand batteries are classified according to quality thereof, a demand quantity of the demand batteries and a demand timing of the demand batteries.

2. The battery information management system according to claim 1,
wherein the database classifies the quality groups of the supply batteries for each application of the supply batteries and stores the information of the supply batteries,
wherein the database classifies the quality groups of the demand batteries for each application of the demand batteries and stores the information of the demand batteries,
wherein the calculation unit calculates the supply quantity of the supply batteries and the supply timing of the supply batteries for each application of the supply batteries, and
wherein the calculation unit calculates the demand quantity of the demand batteries and the demand timing of the demand batteries for each application of the demand batteries.

3. The battery information management system according to claim 1,
wherein the calculation unit predicts a future deterioration state of the supply batteries using a time change rate of the deterioration states of the supply batteries, and reflects a prediction result in the database as the deterioration state data of the supply batteries.

4. The battery information management system according to claim 1,
wherein the calculation unit calculates an estimated price at a predetermined timing of batteries supplied in the market using the supply quantity of the supply batteries, the supply timing of the supply batteries, the demand quantity of the demand batteries, and the demand timing of the demand batteries, and presents a result thereof.

5. The battery information management system according to claim 1,
wherein the calculation unit calculates an estimated quality at a predetermined timing of batteries supplied in the market using the information of the supply batteries and the information of the demand batteries, and presents a result thereof.

6. The battery information management system according to claim 1,
wherein the calculation unit acquires new battery supply forecast data predicting a supply quantity of new batteries by region,
wherein the calculation unit predicts a supply quantity of used batteries by region using the new battery supply forecast data, and
wherein the calculation unit calculates an estimated price at a predetermined timing of batteries supplied in the market using a prediction result of the predicted supply quantity of used batteries, and presents a result thereof.

7. The battery information management system according to claim 2,
wherein, when the deterioration state of the supply batteries is equal to or greater than a first threshold value, the calculation unit selects, as an application of the supply batteries, rebalancing for equalizing states of charge of a plurality of batteries,
wherein, when the deterioration state of the supply batteries is equal to or less than the first threshold value and equal to or greater than a second threshold value, the calculation unit selects, as an application of the supply batteries, rebuilding for regenerating the supply batteries, and
wherein the calculation unit calculates the supply quantity and supply timing of the supply batteries for which the rebuilding has been selected, and presents a result thereof.

8. The battery information management system according to claim 2,
wherein the calculation unit selects, according to the deterioration state of the supply batteries, diversion of the supply batteries to another application as an application of the supply batteries, and
wherein the calculation unit calculates the supply quantity and supply timing of the supply batteries for which the diversion has been selected, and presents a result thereof.

9. The battery information management system according to claim 8,
wherein the database stores locations of the supply batteries, and
wherein the calculation unit presents at least one of the specification data of the supply batteries for which the diversion has been selected, the deterioration state data of the supply batteries for which the diversion has been selected, and the use history data of the supply batteries for which the diversion has been selected, together with the locations of the supply batteries.

10. The battery information management system according to claim 2,
wherein the database stores the information of the supply batteries for each owner who owns the supply batteries,
wherein the calculation unit receives a requirement for the supply batteries desired by a demander who needs the supply batteries, and
wherein the calculation unit searches the database for the supply batteries and owners thereof that match the requirement, and presents a result thereof.

11. The battery information management system according to claim 1,
wherein the calculation unit diagnoses a deterioration state for each battery cell included in the battery, and presents a result thereof.

12. The battery information management system according to claim 1,
wherein the calculation unit estimates at least one of a price, a supply quantity, a supply timing, a demand quantity, and a demand timing of the battery based on transaction price results of the battery on the battery information management system or a transaction history of the battery in the market.

13. The battery information management system according to claim 1,
wherein the calculation unit acquires, as the information of the supply batteries, a contractual condition defining a period during which use of the supply batteries is permitted, and
wherein the calculation unit estimates at least one of the supply quantity and the supply timing according to the contractual condition.
